# EUROPÄISCHE PATENTANMELDUNG

(11) **EP 2 947 700 A1**
(43) Veröffentlichungstag der Anmeldung: **25.11.2015**
(21) Anmeldenummer: 15166994.2
(22) Anmeldetag: 08.05.2015
(51) Int. Cl.: H01L 31/048, H02S 40/36, H01L 31/02

(54) **Kleinformatiges Photovoltaikmodul als glas-glas- oder glas-folie-laminat**

(30) Priorität: 21.05.2014 DE 102014007516; 24.06.2014 DE 102014108810
(71) Anmelder: SOLARWATT GmbH, 01109 Dresden (DE)
(72) Erfinder: Ehrig, Matthias, 01159 Dresden (DE); Wald, Dietmar, 01189 Dresden (DE); Schubert, Amrei, 01731 Kreischa (DE)
(74) Vertreter: Kruspig, Volkmar

(57) **Zusammenfassung**

Die Erfindung betrifft ein kleinformatiges Photovoltaikmodul als Glas-Glas- oder Glas-Folie-Laminat mit über Querverbinder innerhalb des Laminats in Reihe geschalteten, weniger als sechs Stringanordnungen, welche jeweils eine Vielzahl von Solarzellen aufweisen, wobei das Rückseitenmaterial eine Durchgangsöffnung zum Herausführen von Anschlussbändern besitzt, sowie eine im Bereich der Durchgangsöffnung befindliche Anschlussdose, welche die Anschlussbänder elektrisch kontaktiert. Erfindungsgemäß erfolgt die Reihenschaltung zwischen den Stringanordnungen auf der Durchgangsöffnungsseite des Photovoltaikmoduls außerhalb der Ebene des Laminatgebildes durch Trennung der jeweiligen Querverbinder und Herausführen der jeweiligen Querverbinderenden in eine weitere Ebene, wobei in der weiteren Ebene die Anschlussdose angeordnet ist.

## Beschreibung

Die Erfindung betrifft ein kleinformatiges Photovoltaikmodul als Glas-Glas- oder Glas-Folie-Laminat mit über Querverbinder innerhalb des Laminats in Reihe geschalteten, weniger als sechs Stringanordnungen, welche jeweils eine Vielzahl von Solarzellen aufweisen, wobei das Glasrückseitenmaterial eine Durchgangsöffnung zum Herausführen von Anschlussbändern besitzt, sowie eine im Bereich der Durchgangsöffnung befindliche Anschlussdose, welche die Anschlussbänder elektrisch kontaktiert, gemäß Oberbegriff des Patentanspruchs 1.

Aus der DE 10 2012 207 168 A1 ist ein Photovoltaikmodul vorbekannt, welches in Reihe geschaltete Stringanordnungen aufweist. Die Stringanordnungen umfassen parallel geschaltete Strings aus Solarzellen. Weiterhin weisen die Strings in Reihe geschaltete Solarzellen auf. In den Stringanordnungen sind die Solarzellen der parallel geschalteten Strings jeweils untereinander ebenfalls parallel geschaltet. Üblicherweise sind die Solarzellen über Zellverbinder in Reihe mit den vorerwähnten Strings verschalten, welche ihrerseits ebenfalls in Form einer Reihenschaltung verbunden sind. Die auf diese Weise verschalteten Solarzellen befinden sich in einer transparenten Einbettungsschicht, welche zwischen einer vorseitigen Glasabdeckung und einer rückseitigen Abdeckung angeordnet ist. Die rückseitige Abdeckung kann dabei ebenfalls aus Glas bestehen, so dass ein Glas-Glas-Laminat gebildet wird. Das Deckmaterial kann hier ein hochtransparentes Solarglas sein, wobei als Rückseitenmaterial prismiertes Solarglas verwendet wird. Das Glas-Glas-Laminat wird dann mittels eines speziellen Verkapselungsmaterials realisiert.

Derartige Glas-Glas-Laminate werden von der SOLARWATT GmbH, Dresden, als Vierstring-Module mit beispielsweise 36 polykristallinen Solarzellen oder aber auch als Sechs-Stringmodule mit beispielsweise 60 polykristallinen Solarzellen angeboten (siehe www.solarwatt.de, Datenblatt Solarwatt 36 STYLE oder Solarwatt 60 P).

Querverbinder für die elektrische Kontaktierung der Solarzellenmodule, aufweisend beabstandet voneinander angeordnete, elektrisch leitfähige Bänder sind in der DE 10 2009 039 370 A1 gezeigt. Der dortige Querverbinder weist darüber hinaus mindestens einen Flachbaustein auf, in welchen Teilbereiche von wenigstens zwei Bändern eingebettet sind. Ein solcher Querverbinder kann zur Verschaltung von Solarzellen in einem Solarzellenmodul eingesetzt werden.

Aus der DE 10 2008 039 932 A1 ist eine Verbindungsvorrichtung zur Verbindung mindestens eines externen elektrischen Leiters mit einem elektrischen Anschlusssystem eines photovoltaischen Solarmoduls bekannt. Diese Verbindungsvorrichtung umfasst ein Gehäuse zur Anordnung an den Solarmodul und eine in dem Verbindergehäuse befindliche Zwischenverbindungsanordnung mit einem ersten Kontaktbereich zur Verbindung mit dem elektrischen Leiter und einen mit dem ersten Kontaktbereich verbundenen zweiten Kontaktbereich zur Verbindung mit dem Anschlusssystem des Solarmoduls.

Die bekannte Verbindungsvorrichtung stellt also ein elektrisches Anschlusssystem der Solarzellen an der von der Bestrahlungsseite abgewandten Rückseite des Solarmoduls mittels elektrischer Leiter dar, wobei diese Leiter in Form von Anschlussfolien oder Anschlussbändern nach außen an einen Verbraucher geführt werden. Zusätzlich sind in einer derartigen Verbindungsvorrichtung, ausgeführt in Form einer Anschlussdose, meist eine oder mehrere Dioden enthalten, die vorgesehen sind, um Ausgleichsströme zwischen im Sonnenlicht befindlichen Solarzellen und im Schatten befindlichen Solarzellen, die unterschiedliche Solarströme und Solarspannungen liefern, zu verhindern. Damit kann unter Nutzung der Bypass-Dioden der entsprechende Modul auch bei teilweiser Verschattung und entsprechend reduzierter Leistung im funktionsfähigen Zustand verbleiben.

Zum Stand der Technik sei noch auf die DE 10 2011 001 061 A1 aufmerksam gemacht. In dieser Druckschrift werden verschiedene Ausführungsbeispiele von Solarzellenverbinder-Elektroden vorgestellt, wobei in Bereichen auf flächigen Elementen Solarzellenverbinder-Trennstellen vorgesehen sind, so dass durch eine jeweilige Trennstelle ein jeweiliges elektrisch leitfähiges Solarzellenverbinder-Element in mehrere, beispielsweise zwei, elektrisch voneinander getrennte Solarzellenverbinder-Teilelemente aufteilbar ist.

Bei großformatigen Photovoltaikmodulen mit sechs und mehr Strings, umfassend beispielsweise 54, 60 oder 72 Solarzellen, können sogenannte Standard-Anschlussdosen mit integrierten Bypass-Dioden eingesetzt werden. Derartige Standard-Anschlussdosen sind aufgrund hoher Fertigungszahlen preisgünstig verfügbar.

Bei kleinformatigen Photovoltaikmodulen mit in der Regel 6 Zoll kristallinen Solarzellen bis zu 48 Zellen je Modul und z.B. vier Strings können derartige Standard-Anschlussdosen nicht eingesetzt werden, und zwar aufgrund der unterschiedlichen Anzahl von notwendigen Bypass-Dioden. Insofern ist es erforderlich, für derartige kleinformatige Photovoltaikmodule spezielle Anschlussdosen zu fertigen, was mit höheren Kosten verbunden ist.

Weiterhin ergibt sich durch die unterschiedliche Handhabung bei der Ausführung des Kontaktierungsvorgangs mit den jeweiligen Anschlussdosen eine geänderte Technologie sowie die Notwendigkeit eines zusätzlichen Querverbinders, was die Fertigungskosten weiter erhöht.

Aus dem Vorgenannten ist es daher Aufgabe der Erfindung, ein weiterentwickeltes kleinformatiges Photovoltaikmodul als Glas-Glas- oder Glas-Folie-Laminat mit über Querverbinder innerhalb des Laminats in Reihe geschaltete, weniger als sechs Stringanordnungen, welche jeweils eine Vielzahl von Solarzellen aufweisen, anzugeben, welches im Bereich einer Anschlussdose ein optimiertes Modullayout besitzt, so dass der Einsatz kostengünstiger Anschlussdosen und insbesondere von Standard-Anschlussdosen, wie sie bei großformatigen Modulen Anwendung finden, möglich ist.

Die Lösung der Aufgabe der Erfindung erfolgt durch die Merkmalskombination nach Patentanspruch 1, wobei die Unteransprüche mindestens zweckmäßige Ausgestaltungen und Weiterbildungen darstellen.

Es wird demnach von einem kleinformatigen Photovoltaikmodul als Glas-Glas- oder Glas-Folie-Laminat mit über Querverbinder innerhalb des Laminats in Reihe geschalteten Stringanordnungen ausgegangen. Die Stringanordnungen weisen jeweils eine Vielzahl von Solarzellen auf.

Das Glasrückseitenmaterial des Laminats besitzt eine Durchgangsöffnung zum Herausführen von Anschlussbändern für den elektrischen Außenanschluss des Moduls. Darüber hinaus ist im Bereich der Durchgangsöffnung eine an sich bekannte Anschlussdose befindlich, welche die Anschlussbänder elektrisch kontaktiert.

Erfindungsgemäß erfolgt die Reihenschaltung zwischen den Stringanordnungen auf der Durchgangsöffnungsseite des Photovoltaikmoduls außerhalb der Ebene des eigentlichen Laminats, und zwar durch Trennung der jeweiligen Querverbinder und Herausführen der jeweiligen Querverbinderenden in eine weitere Ebene. In dieser weiteren Ebene ist dann die bereits erwähnte Anschlussdose angeordnet.

Die in der Laminatebene getrennten Querverbinder sind als Anschlussbänder in die Anschlussdose geführt und dort unmittelbar oder über eine Brücke elektrisch verbunden.

Das Layout des Moduls im Anschlussdosenbereich wird so angepasst, dass die Stringpolarität des Moduls der Ausführung der Anschlussdose und dort befindlichen Bypass-Dioden entspricht.

Aufgabengemäß kann nun als Anschlussdose eine Standard-Dose für großformatige Photovoltaikmodule mit sechs und mehr Stringanordnungen auch bei kleinformatigen Modulen eingesetzt werden.

Bei einer bevorzugten Ausführungsform weist das kleinformatige Photovoltaikmodul vier Stringanordnungen auf. Das entsprechende Modul kann dann 36 oder 48, in der Regel 6-zollige Solarzellen umfassen. Erfindungsgemäß ist bei dem vorgestellten Modullayout nur eine einzige Durchgangsöffnung zum Herausführen der Anschlussbänder erforderlich, was die Bezugskosten für das Rückglas reduziert und zu einer höheren Hagelschlagbeständigkeit und damit Modulfestigkeit führt.

Bei einer Ausführungsform kann die Anschlussdose vierschienig ausgebildet sein, wobei zwei Schienen oder dort befindliche Schienenklemmen die jeweiligen Querverbinderenden zum Erhalt der Reihenschaltung aufnehmen und diese Schienen oder Schienenklemmen elektrisch verbunden sind.

Bei einer weiteren Ausführungsform kann die Anschlussdose dreischienig ausgebildet werden, wobei eine der Schienen oder Schienenklemmen die jeweiligen Querverbinderenden aufnimmt und diese hierdurch unmittelbar kontaktiert, um die gewünschte Reihenschaltung zu realisieren. Bei dieser letztgenannten Ausführungsform können die jeweiligen Querverbinderenden doppelt gelegt in die Schienenklemme eingeführt werden.

Die Erfindung soll nachstehend anhand eines Ausführungsbeispiels und einer Figur näher erläutert werden.

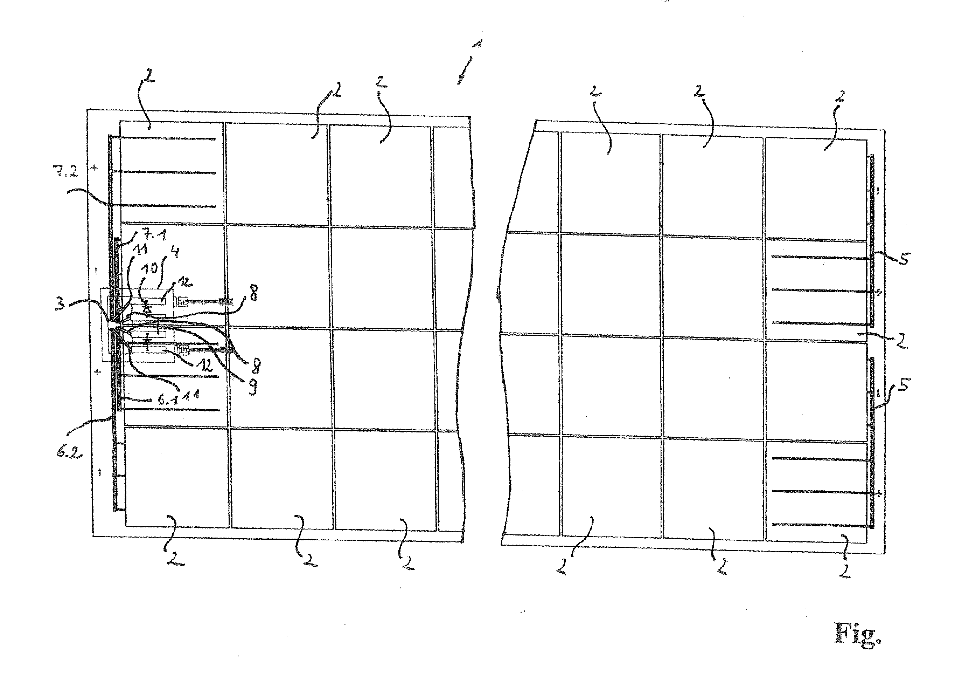

Die Figur zeigt hierbei eine Prinzipdarstellung eines kleinformatigen Photovoltaikmoduls als Glas-Glas-Laminat.

Das Photovoltaikmodul 1 gemäß der figürlichen Abbildung (der Übersichtlichkeit halber teilweggebrochen) besteht aus einem hochtransparenten Solarglas als Deckmaterial und einem prismierten Solarglas als Rückseitenmaterial. Insgesamt sind vier Stringanordnungen vorhanden, welche jeweils eine Vielzahl von Solarzellen 2 aufweisen. Das Glasrückseitenmaterial weist eine Durchgangsöffnung 3 auf, die sich im Bereich konkret unterhalb einer Anschlussdose 4 befindet.

Die gewünschte Reihenschaltung der Strings wird über Querverbinder 5, die sich innerhalb des Laminats befinden, realisiert.

Auf der Seite der Durchgangsöffnung 3 erfolgt die Reihenschaltung zwischen den Stringanordnungen außerhalb der Ebene des Laminatgebildes. Diesbezüglich sind die dort befindlichen Querverbinder 7.1;7.2 und 6.1;6.2 getrennt und es sind die jeweiligen Querverbinderenden über die Durchgangsöffnung 3 herausgeführt, so dass die Querverbinderenden in eine weitere Ebene gelangen. Diese weitere Ebene ist die Ebene der Anschlussdose 4.

Die in der Figur gezeigten inneren Querverbinderenden 8 werden als Anschlussbänder in die Anschlussdose geführt und dort unmittelbar oder über eine Brücke 9 verbunden. Die gewünschte Gesamtreihenschaltung des Photovoltaikmoduls 1 wird durch Enden der Querverbinder 7.1 und 6.1 realisiert. Die Stringpolarität, gekennzeichnet mit den Symbolen + und -, des Moduls wird der Ausführung der Anschlussdose 4 und den dort befindlichen Bypass-Dioden 10 angepasst.

Die freien Seiten der Querverbinderenden 11 stehen mit äußeren Schienen bzw. Schienenklemmen 12 und damit den vorerwähnten Bypass-Dioden 10 in Verbindung.

Bei der in der Figur gezeigten Ausführungsform ist es möglich, bei einem kleinformatigen Photovoltaikmodul mit vier Stringanordnungen eine Standard-Anschlussdose einzusetzen, die ansonsten nur für großformatige Photovoltaikmodule zur Anwendung kommt.

Dabei ist die üblicherweise vorhandene mittlere, dritte Bypass-Diode einer solchen Anschlussdose für Sechs-String-Module entweder mit einer Kontaktbrücke zu überbrücken, was über die oftmals vorhandenen Reparaturklemmen für Ersatzdioden erfolgen kann, oder es wird Anschlussdosen-herstellerseitig die dritte Diode bereits durch eine Kontaktbrücke ersetzt. Letzteres reduziert die Bezugskosten der Anschlussdose aufgrund der fehlenden mittleren, dritten Bypass-Diode.

Alternativ kann gemäß Ausführungsbeispiel auch weiterhin der Einsatz bisheriger Anschlussdosen mit zwei Bypass-Dioden erfolgen, indem die Querverbinderenden 8 beide in eine vorhandene mittlere Schiene bzw. Schienenklemme eingeführt werden, insofern selbige für die doppelte Querverbinderdicke bzw. das entsprechende Bändchenende ausgelegt ist.

Erfindungsgemäß kann durch die nur eine erforderliche Durchgangsöffnung 3 eine Reduzierung der Bezugskosten für das Rückglas erfolgen und es liegt eine höhere mechanische Festigkeit im Sinne einer höheren Hagelschlagbeständigkeit vor.

Für das mit der Fertigung der Module beauftragte Personal stellt sich ein vereinheitlichtes Modullayout und eine einheitliche Dosenmontage dar, was der Qualitätssicherung dient und die Fertigungskosten senkt.

Weiterhin reduziert sich der Aufwand für die Lagerhaltung der Anschlussdosen.

An Stelle der Brücke 9 kann eine Sicherheitsabschaltvorrichtung, beispielsweise in Form eines elektronischen Schalters oder einer Sicherung, insbesondere eine Schmelzsicherung vorgesehen sein.

## Patentansprüche

1. Kleinformatiges Photovoltaikmodul (1) als Glas-Glas- oder Glas-Folie-Laminat mit über Querverbinder(5) innerhalb des Laminats in Reihe geschalteten, weniger als sechs Stringanordnungen, welche jeweils eine Vielzahl von Solarzellen (2) aufweisen, wobei das Rückseitenmaterial eine Durchgangsöffnung (3) zum Herausführen von Anschlussbändern besitzt, sowie eine im Bereich der Durchgangsöffnung (3) befindliche Anschlussdose (4), welche die Anschlussbänder elektrisch kontaktiert,
**dadurch gekennzeichnet, dass**
die Reihenschaltung zwischen den Stringanordnungen auf der Durchgangsöffnungsseite des Photovoltaikmoduls (1) außerhalb der Ebene des Laminates durch Trennung der jeweiligen Querverbinder (6.1;6.2;7.1;7.2) und Herausführen der jeweiligen Enden der Querverbinder (7.1;6.1) in eine weitere Ebene erfolgt, wobei in der weiteren Ebene die Anschlussdose (4) angeordnet ist, wobei die in der Laminatebene getrennten Querverbinder (6.1;6.2;7.1;7.2) als Anschlussbänder in die Anschlussdose (4) geführt und dort unmittelbar oder über eine Brücke (9) verbunden sind, sowie als Anschlussdose (4) eine Standarddose für großformatige Photovoltaikmodule mit sechs und mehr Stringanordnungen eingesetzt ist.

2. Kleinformatiges Photovoltaikmodul nach Anspruch 1,
**dadurch gekennzeichnet, dass**
selbiges vier Stringanordnungen aufweist.

3. Kleinformatiges Photovoltaikmodul nach Anspruch 2,
**dadurch gekennzeichnet, dass**
selbiges 36 oder 48 Solarzellen umfasst.

4. Kleinformatiges Photovoltaikmodul nach einem der vorangegangenen Ansprüche,
**dadurch gekennzeichnet, dass**
eine einzige Durchgangsöffnung (3) zum Herausführen der Anschlussbänder vorgesehen ist.

5. Kleinformatiges Photovoltaikmodul nach einem der vorangegangenen Ansprüche,
**dadurch gekennzeichnet, dass**
die Anschlussdose (4) vierschienig ausgebildet ist, wobei zwei Schienen oder Schienenklemmen die jeweiligen Querverbinderenden (8) zum Erhalt der Reihenschaltung aufnehmen und diese Schienen elektrisch verbunden sind.

6. Kleinformatiges Photovoltaikmodul nach einem der Ansprüche 1 bis 4,
**dadurch gekennzeichnet, dass**
die Anschlussdose (4) dreischienig ausgebildet ist, wobei eine der Schienen oder Schienenklemmen die jeweiligen Querverbinderenden aufnimmt und diese hierdurch unmittelbar kontaktiert, um die gewünschte Reihenschaltung zu realisieren.

7. Kleinformatiges Photovoltaikmodul nach Anspruch 6,
**dadurch gekennzeichnet, dass**
die jeweiligen Querverbinderenden doppelt gelegt in die entsprechende Schienenklemme eingeführt sind.

8. Kleinformatiges Photovoltaikmodul nach Anspruch 1,
**dadurch gekennzeichnet, dass**
die Brücke (9) als elektronischer Schalter oder Sicherung, insbesondere thermische Sicherung, ausgebildet ist.

9. Kleinformatiges Photovoltaikmodul nach einem der vorangegangenen Ansprüche,
**dadurch gekennzeichnet, dass**
das Rückseitenmaterial aus Glas oder einer Polymerfolie oder einem Glas-Polymerfoliengebilde besteht.
